# EUROPEAN PATENT APPLICATION

(11) **EP 2 947 698 A1**
(43) Date of publication of application: **25.11.2015**
(21) Application number: 14169491.9
(22) Date of filing: 22.05.2014
(51) Int. Cl.: H01L 31/0232, H01L 31/0236, H01L 21/3065, H01L 21/311

(54) **Photonic semiconductor device for enhanced propagation of radiation and method of producing such a semiconductor device**

(71) Applicant: ams AG, 8141 Unterpremstätten (AT)
(72) Inventor: Koppitsch, Günther, 8501 Lieboch (AT); Minixhofer, Rainer, 8141 Unterpremstätten (AT)
(74) Representative: Epping - Hermann - Fischer

(57) **Abstract**

The semiconductor device comprises a semiconductor substrate (2), a transition layer (5) in or on the semiconductor substrate, the transition layer allowing propagation of incident radiation (7) according to a refractive index, and a photonic component (4) facing the transition layer. A surface (6) of the transition layer is structured such that the effective refractive index is gradually changed through the transition layer with changing distance from the photonic component.

## Description

WO 2013/171284 A1 discloses an optical device with a nano structure comprising a plurality of cone shaped structures distributed non-periodically on the surface of the device. A method of manufacturing the nano structure comprises the steps of providing a silicon carbide or gallium nitride substrate, forming a thin film of a masking material on a surface area, treating the thin film to form nano islands, anisotropically etching the substrate and at least a part of the thin film to form a non-periodical nano structure comprising a plurality of cone shaped surface structures.

US 2013/0340824 A1 discloses a photovoltaic device with antireflection means on a light-receiving surface, provided by nano-structured or black silicon. This results in a gradual change from a low porosity near the bulk material to a high porosity near the ambient air.

It is an object of the present invention to disclose a photonic semiconductor device for enhanced propagation of radiation between regions of different indices of refraction. It is a further object to disclose a method of producing such a semiconductor device.

This object is achieved with the semiconductor device according to claim 1 and with the method of producing a semiconductor device according to claim 10. Embodiments and variants derive from the dependent claims.

The semiconductor device comprises a semiconductor substrate, a transition layer in or on the semiconductor substrate, and a photonic component facing the transition layer. The transition layer allows a propagation of radiation according to a refractive index and comprises a structured surface affecting the propagation of radiation according to a gradual change of the refractive index through the transition layer with changing distance from the photonic component.

In an embodiment of the semiconductor device, the transition layer comprises the same material throughout.

In a further embodiment, the photonic component is arranged outside the semiconductor substrate, and the gradual change of the refractive index is an increase with increasing distance from the photonic component, in particular an increase from a value below 1.01 to a value above 1.01.

In a further embodiment, the photonic component is arranged in the semiconductor substrate, and the gradual change of the refractive index is a decrease with increasing distance from the photonic component, in particular a decrease from a value above 1.01 to a value below 1.01.

In a further embodiment, the semiconductor substrate and the transition layer are silicon.

In a further embodiment, the surface of the transition layer is structured by protrusions or stubs growing thinner from base to top. In particular, the protrusions or stubs may have a surface in the shape of one sheet of a circular hyperboloid of two sheets.

The method of producing the semiconductor device comprises providing a transition layer, which allows propagation of radiation according to a refractive index, in or on a semiconductor substrate, arranging a photonic component facing the transition layer, and structuring a surface of the transition layer by etching such that the propagation of radiation is affected according to a gradual change of the refractive index through the transition layer with changing distance from the photonic component.

In a variant of the method, the transition layer is formed as an integral part of the semiconductor substrate, and the surface of the transition layer comprises a surface area of the semiconductor substrate, which is structured by etching.

In a further variant of the method, the transition layer is etched in silicon by an etching process that deviates in a controlled way from the formation of black silicon. The etching process may comprise reactive ion etching.

In a further variant of the method, the surface of the transition layer is structured by etching protrusions or stubs growing thinner from base to top.

In a further variant of the method, the photonic component is mounted on a carrier, and the semiconductor substrate is fastened to the carrier, so that the surface of the transition layer is arranged opposite the photonic component.

The following is a detailed description of examples of the semiconductor device and the production method in conjunction with the appended figures.
- Figure 1: is a cross section of an embodiment of the semiconductor device.
- Figure 2: is a perspective view of a section of the embodiment according to Figure 1 including a transition layer.
- Figure 3: is a perspective view of a stub forming part of the surface structure of the transition layer.
- Figure 4: is a perspective view according to Figure 3 for a further embodiment.
- Figure 5: is a cross section of a further embodiment.

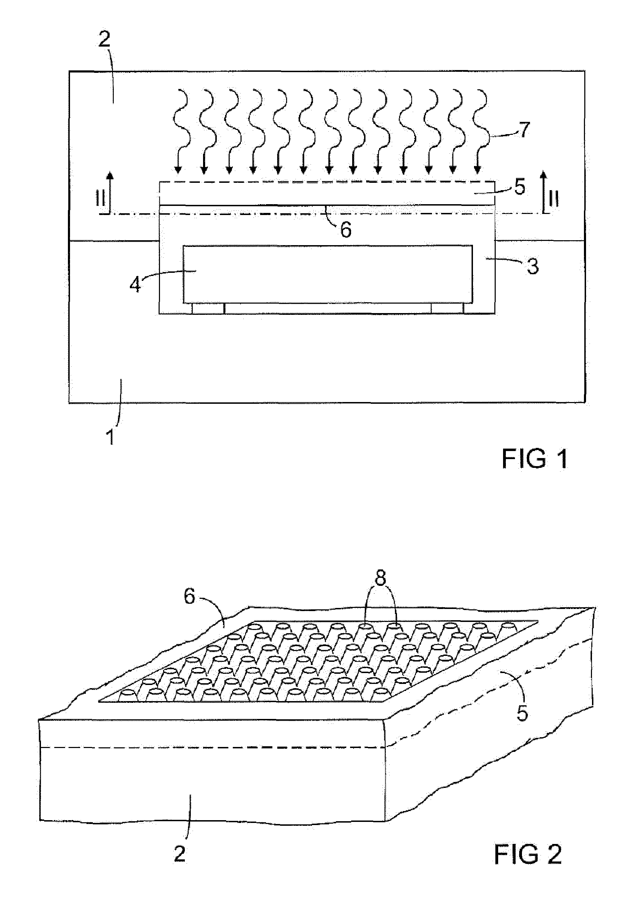

Figure 1 is a cross section of an embodiment of the semiconductor device. The arrangement comprises a recessed carrier 1, which may be a semiconductor substrate, for instance, and a recessed semiconductor substrate 2, which are fastened to one another and thus form a cavity 3, which may contain ambient air or be evacuated, for example. The cavity 3 may instead be formed by a recess of the carrier 1 and a plane surface of the semiconductor substrate 2 or by a plane surface of the carrier 1 and a recess of the semiconductor substrate 2. In the cavity 3 a photonic component 4 is mounted on the carrier 1 opposite a surface 6 of a transition layer 5 of the semiconductor substrate 2. The transition layer 5, which can be silicon, for instance, may form an integral part of the semiconductor substrate 2 or be a dedicated layer applied to the substrate surface. The transition layer 5 is provided to allow propagation of incident radiation 7 according to a refractive index.

The difference between the refractive indices of two different materials generates refraction of radiation according to Snell's law and an attenuation of the amplitude of the radiation with the transition from one material to the other. These effects can be avoided or at least reduced if the refractive index is gradually changed in an intermediate region by a continuous variation of the material composition or by a sequence of different materials whose refractive indices differ only slightly, in order to adapt the conditions for the propagation of radiation between regions of different refractive indices. Instead, the effect of the different refractive indices can be mitigated by a suitable structure of the interface in such a manner that the propagation of radiation is affected according to a gradual change of the refractive index through the structured layer. The semiconductor device according to the invention makes use of the latter option.

The surface 6 of the transition layer 5 is provided with a structure that generates a gradual change of the effective refractive index with the change of the distance from the photonic component 4. Thus the propagation of radiation is affected in a way similar to a gradual change of the actual refractive index of the material through which the radiation propagates. The change of the effective refractive index through the transition layer 5 depends on this surface structure. The refractive index of the material of the transition layer 5 itself is not changed. The material of the transition layer 5 can therefore be the same throughout.

The structure of the surface 6 may be produced on a nanoscale level by nanotechnology like nanoimprint lithography, for instance, which is known per se in semiconductor technology. A surface structure comprising a plurality of protrusions in the shape of cones can be generated by deep reactive ion etching into a silicon surface, for example. Whereas in a conventional etching process erroneous operation or malfunction of the equipment may result in an undesired surface comprising needle-shaped protrusions known as "black silicon" or "silicon-grass," an appropriate adaptation of the etching parameters enables the formation of a surface structure providing a gradual change of the effective refractive index. For this purpose, silicon etching can be modified to deviate in a controlled way from the formation of black silicon, in order to produce a surface structure comprising stubs or protrusions of essentially conical shape having dimensions appropriate for a gradual change of the effective refractive index. Infrared light, for instance, can easily enter or leave bulk silicon through such a structured surface, in particular from the semiconductor substrate 2 passing the transition layer 5 into the cavity 3 of the embodiment according to Figure 1.

In embodiments of the semiconductor device, the photonic component 4 may comprise a passive infrared sensor, like a bolometer, or a sensor for the detection of visible light, for example. Silicon, which may be the material of the substrate 2, is transparent to infrared radiation with a wavelength in the range from 9 µm to 11 µm. Between the bulk material of the semiconductor substrate 2 and the cavity 3, the transition layer 5 provides a gradual change of the effective refractive index, which increases the light efficiency typically by up to 50 %. If the recess in the semiconductor substrate 2 is produced by deep reactive ion etching, the etching of the surface structure can immediately follow on an appropriate change of the etching parameters.

Figure 2 is a perspective view of a section of the embodiment according to Figure 1 and shows the transition layer 5 on the semiconductor substrate 2 with its surface 6 structured by protrusions or stubs 8 of essentially conical shape. The direction of view onto the structured surface 6 is indicated in Figure 1 by arrows. The arrangement, number, distribution, size and shape of the protrusions or stubs 8, which are schematically drawn in Figure 2, are arbitrary and can be adapted to individual requirements of the embodiments of the semiconductor device.

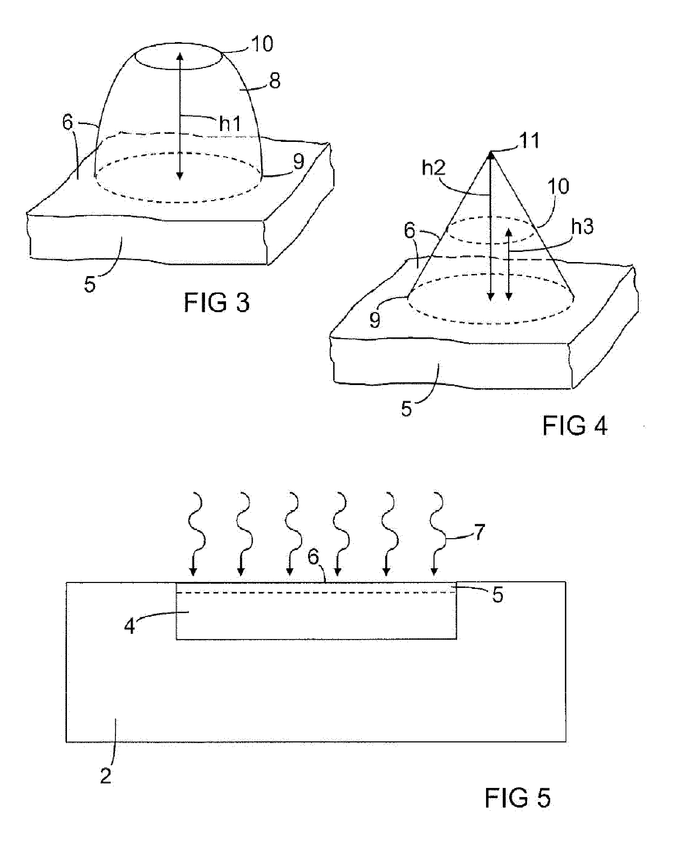

Figure 3 is a perspective view of one of a plurality of protrusions or stubs 8 forming the structure of the surface 6 of the transition layer 5. The protrusion or stubs 8 preferably grows thinner from its base 9 to its top 10. Although the protrusions or stubs 8 are intended to be essentially equal, the shape and size of the protrusions or stubs 8 may vary to some degree, owing to the production process. The structured surface 6 is schematically represented in Figure 3 and will in practice not be reproduced in the same idealized and symmetrical form. The lateral surface or nappe of the protrusion or stub 8 can especially have the form of a section of one sheet of a circular hyperboloid of two sheets, for instance, which is limited or truncated at the appropriate height. In Cartesian coordinates x, y, z, a circular hyperboloid of two sheets is defined by the equation (x² + y²) + a² (b² - z²) = 0, a and b being constant real numbers with a ≠ 0. The nappe of the protrusion or stub 8 of height h1, defined with reference to a suitably oriented coordinate system, comprises all triples x, y, z satisfying the above equation with the values of z lying in the range from c to d, c ≤ z ≤ d, c and d being non-negative constant real numbers with b² ≤ c² < d² and d - c = h1.

Figure 4 is a perspective view of a protrusion or stub 8 forming part of the structure of the surface 6 of the transition layer 5 for a further embodiment, in which the nappe of the protrusion or stub 8 is a cone of height h2, measured along its axis from the base 9 to the apex 11. The above equations also apply to this special case where 0 = b = c, and d = h2 is the height h2 of the cone. The cone may be truncated and comprise a surface forming its top 10, which is indicated in Figure 4 by a broken elliptical curve. In this case 0 = b < c with d - c = h3 being the height h3 of the truncated cone.

Figure 5 is a cross section according to Figure 1 for a further embodiment, wherein the photonic component 4 is integrated in the semiconductor substrate 2. The structured surface 6 may be an outer surface of the semiconductor device or covered with at least one further layer like an antireflective layer or a passivation layer, for instance. Further components, in particular components of a CMOS circuit, for instance, can be integrated in the semiconductor substrate 2.

In the embodiment according to Figure 1, wherein the photonic component 4 is arranged outside the semiconductor substrate 2, the gradual change of the effective refractive index is an increase with increasing distance from the photonic component 4, in particular an increase from a value below 1.01 to a value above 1.01. The evacuated cavity 3 may be supposed to have a refractive index of 1 or a number near to 1, hence below 1.01, whereas the semiconductor material has a refractive index well above 1.01.

In the embodiment according to Figure 5, wherein the photonic component 4 is integrated in the semiconductor substrate 2, the gradual change of the effective refractive index is a decrease with increasing distance from the photonic component 4, in particular a decrease from a value above 1.01, appertaining to the semiconductor material, to a value below 1.01, which may be the refractive index of ambient air.

The described semiconductor device and method of production provide a novel means for photonic devices to substitute conventional gradient-index (GRIN) layers. An important advantage is the possibility to create the layer generating the gradual change of the effective refractive index as an integral part of a semiconductor substrate by just etching the surface by an etching method that is compatible with standard processes like a CMOS process. Hence there is no need for a layer deposition or layer transfer, and production costs will not essentially be increased by the application of this method. The method can be implemented on a standard DRIE (deep reactive ion etching) equipment using a photoresist mask to structure the whole area where the structured surface is to be generated.

### List of reference numerals

- 1: carrier
- 2: semiconductor substrate
- 3: cavity
- 4: photonic component
- 5: transition layer
- 6: structured surface
- 7: incident radiation
- 8: protrusion, stub
- 9: base
- 10: top
- 11: apex
- h1: height of a truncated circular hyperboloid
- h2: height of a cone
- h3: height of a truncated cone

## Claims

1. A semiconductor device, comprising:
- a semiconductor substrate (2),
- a transition layer (5) in or on the semiconductor substrate (2), the transition layer (5) allowing a propagation of radiation according to a refractive index, and
- a photonic component (4) facing the transition layer (5), **characterized in that**
- the transition layer (5) comprises a structured surface (6) affecting the propagation of radiation according to a gradual change of the refractive index through the transition layer (5) with changing distance from the photonic component (4).

2. The semiconductor device of claim 1, wherein the transition layer (5) comprises the same material throughout.

3. The semiconductor device of claim 1 or 2, wherein
the photonic component (4) is arranged outside the semiconductor substrate (2), and
the gradual change of the refractive index is an increase with increasing distance from the photonic component (4).

4. The semiconductor device of claim 3, wherein the increase is from a value below 1.01 to a value above 1.01.

5. The semiconductor device of claim 1 or 2, wherein
the photonic component (4) is arranged in the semiconductor substrate (2), and
the gradual change of the refractive index is a decrease with increasing distance from the photonic component (4).

6. The semiconductor device of claim 5, wherein the decrease is from a value above 1.01 to a value below 1.01.

7. The semiconductor device of one of claims 1 to 6, wherein the semiconductor substrate (2) and the transition layer (5) are silicon.

8. The semiconductor device of one of claims 1 to 7, wherein the structured surface (6) of the transition layer (5) comprises stubs or protrusions (8) growing thinner from base (9) to top (10, 11).

9. The semiconductor device of claim 8, wherein the stubs or protrusions (8) have a surface in the shape of a section of one sheet of a circular hyperboloid of two sheets.

10. A method of producing a semiconductor device, comprising:
- providing a transition layer (5), which allows propagation of radiation according to a refractive index, in or on a semiconductor substrate (2), and
- arranging a photonic component (4) facing the transition layer (5),
**characterized in that**
- a surface (6) of the transition layer (5) is structured by etching such that the propagation of radiation is affected according to a gradual change of the refractive index through the transition layer (5) with changing distance from the photonic component (4).

11. The method of claim 10, wherein
the transition layer (5) is formed as an integral part of the semiconductor substrate (2), and
the surface (6) of the transition layer (5) comprises a surface area of the semiconductor substrate (2), the surface area being structured by etching.

12. The method of claim 10 or 11, wherein the transition layer (5) is etched in silicon by an etching process that deviates in a controlled way from the formation of black silicon.

13. The method of claim 12, wherein the transition layer (5) is formed by reactive ion etching.

14. The method of one of claims 10 to 13, wherein the surface (6) of the transition layer (5) is structured by etching stubs or protrusions (8) growing thinner from base (9) to top (10, 11).

15. The method of one of claims 10 to 14, wherein
the photonic component (4) is mounted on a carrier (1), and
the semiconductor substrate (2) is fastened to the carrier (1), so that the surface (6) of the transition layer (5) is arranged opposite the photonic component (4).
